# EUROPEAN PATENT APPLICATION

(11) **EP 4 737 913 A1**
(43) Date of publication of application: **06.05.2026**
(21) Application number: 25207603.9
(22) Date of filing: 08.10.2025
(51) Int. Cl.: G01R 1/067, G01R 31/28

(54) **HIGH-SPEED DIGITAL TESTING ON CIRCUIT BOARDS USING MODIFIED RF TESTERS**

(30) Priority: 30.10.2024 US 202463714073 P; 18.03.2025 US 202519083286
(71) Applicant: R&D Circuits, San Jose, CA 95134 (US); Acculogic Inc., Markham, ON L3R 5B1 (CA)
(72) Inventor: FURNITUREWALA, Quaid Joher, San Jose, 95134 (US); LAI, Henry Wah, San Jose, 95134 (US); LATHROP, Matthew Macneill, San Jose, 95134 (US); DEHKORDI, Karim, San Jose, 95134 (US); PARASCHIV, Bogdan, San Jose, 95134 (US); NIE, Wing Lai, San Jose, 95134 (US); YU, Xin, San Jose, 95134 (US); WU, Wan Sheng, San Jose, 95134 (US); SHIN, Jeremy Nicholas, San Jose, 95134 (US)
(74) Representative: Meissner Bolte Partnerschaft mbB

(57) **Abstract**

In various embodiments, a method comprises positioning, by a testing probe module, a probe head relative to a location of a device under test, wherein the probe head and the testing probe module are included in a test device, acquiring, by a borescope included in the test device, an image of a probe head location relative to the location of the device under test, and contacting, by the probe head, the location on the device under test.

## Description

### CROSS-REFERENCE TO RELATED APPLICATIONS

This application claims priority benefit of United States Provisional Patent Application titled, "RF AND HIGH-SPEED DIGITAL TESTING ON CIRCUIT BOARDS USING MODIFIED RF TESTERS," filed on October 30, 2024, and having Serial No. 63/714,073. The subject matter of this related application is hereby incorporated herein by reference.

### BACKGROUND

### Field of the Various Embodiments

This application relates to systems and methods for reliable test tooling for packaged integrated circuits (IC) devices, and more specifically, to high-speed digital testing on circuit boards using modified radio frequency (RF) testers.

### Description of the Related Art

Currently, printed circuit boards (PCBs) operate at over a large range of operating frequencies. Due to operation at such frequencies, PCBs are thus subject to degradation in quality due to irregularities such as discontinuities in impedance, impairments of inductance, impairments in capacitance, or back drilling effects. Accordingly, reliable test tooling for PCBs is necessary to detect any irregularities that are included on a given PCB assembly (PCBA). Various testing devices, such as oscilloscopes, spectrum analyzers, vector network analyzers (VNAs), signal generators, and power meters are used to perform various types of signal integrity analysis to detect irregularities within defined frequency ranges.

Robotic positioning systems are mechanisms that enable precise movement and placement of test probes. These robotic positioning systems perform engineered repeatable operations, enabling consistency in testing portions of a circuit board. Various automated tester systems include multiple probes that simultaneously engage with components on a PCBA. Use of such automated testing equipment enables a tester to quickly perform multiple measurements. Automated testing equipment is designed to perform accurate, repeatable, and efficient operations and greatly speed the process of detecting any irregularities on a PCBA.

At least one drawback of automated probe testers is that such systems do not accurately test PCBAs that are to be operated at high frequencies. For example, various PCBs are fabricated with various designs that are configured to operate above 5 GHz, with some designs configured to operate above 40 GHz. Many conventional automated testers include components, such as differential probes, that accurately test over a narrow band of frequencies, mainly operating below 1 GHz. Some conventional testing systems include various testing components that enable testing of a PCBA at high frequencies, such as probes, cables, and connectors that are compatible with the impedance and bandwidth being tested of frequencies above 1 GHz or 40 GHz. However, even these probes, cables, and connectors for higher frequencies require contact at a particular location of the PCBA to avoid mismeasurement of data, or to shield the circuit from external interference. Conventional testing systems, though, do not currently provide the requisite precise control of probes to contact specific locations of a PCBA with a specific force. Instead, the necessary control of probes needed for high frequencies requires manual intervention and is thus time-consuming for the tester. For example, manual RF testing for a circuit board with only 100 components at high frequencies would take days for a tester to properly test.

In view of the foregoing, what is needed in the art is an automated technique to perform testing on circuit boards at high frequencies.

### SUMMARY

In various embodiments, a method comprises positioning, by a testing probe module, a probe head relative to a location of a device under test, where the probe head and the testing probe module are included in a test device, acquiring, by a borescope included in the test device, an image of a probe head location relative to the location of the device under test, and contacting, by the probe head, the location on the device under test.

At least one technical advantage of the disclosed techniques relative to the prior art is that, with the disclosed testing device, automated testing systems can acquire electrical measurements related to the operation of components of a printed circuit board assembly when operating at high frequencies. In particular, by using the disclosed techniques to validate the landing of a probe head on a location of the printed circuit board assembly, the probe testing module can automatically calibrate and confirm a proper connection between the probe testing module and components of the circuit board assembly before acquiring the electrical measurements. Consequently, automated testing systems can thus accurately test printed circuit board assemblies at high frequencies and minimize manual intervention. Further, the disclosed techniques can control the contact impedance transition between the probe head and the printed circuit board assembly to minimize signal degradation test signals at high frequencies, such as frequencies above 40 GHz. These technical advantages represent one or more technological improvements over prior art approaches.

### BRIEF DESCRIPTION OF THE DRAWINGS

So that the manner in which the above recited features of the various embodiments can be understood in detail, a more particular description of the inventive concepts, briefly summarized above, may be had by reference to various embodiments, some of which are illustrated in the appended drawings. It is to be noted, however, that the appended drawings illustrate only typical embodiments of the inventive concepts and are therefore not to be considered limiting of scope in any way, and that there are other equally effective embodiments.
Figure 1 illustrates views of a section of an example RF test system, according to various embodiments;
Figure 2 illustrates another example automated test system, according to various embodiments;
Figure 3 illustrates an example RF probe module included in the example automated testing system of Figure 2, according to various embodiments;
Figure 4 illustrates another view of the example RF probe module of Figure 3, according to various embodiments;
Figure 5 illustrates an image captured by the borescope included in the example RF probe of Figure 3, according to various embodiments;
Figure 6 illustrates an example automated test system of Figure 2 performing a test of a device under test, according to various embodiments; and
Figure 7 is a flow diagram of method steps for testing of a device under test, according to various embodiments.

### DETAILED DESCRIPTION

In the following description, numerous specific details are set forth to provide a more thorough understanding of the various embodiments. However, it will be apparent to one skilled in the art that the inventive concepts may be practiced without one or more of these specific details.

An automated testing system disclosed herein enables accurate electrical measurements of printed circuit board assemblies operating at high frequencies, including frequencies above 40 GHz. The automated testing system includes multiple shuttles that contain testing probe modules. Each testing probe module includes a probe head that is movable and rotatable to contact the printed circuit board at a target location using a target orientation. A calibration module included in the automated testing system performs optical calibration and electrical calibration to minimize inconsistencies associated with a loop formed by the testing probe module contacting a component on the printed circuit board. The shuttle includes a probe head, a borescope, and the testing probe module, which further includes a force sensor. During testing of the printed circuit board assembly, the shuttle and the testing probe module move the probe head to a desired location and a desired position. The probe module and probe head "flies" over electronic components along one or more axes (e.d., X and Y axes). Once at the target position along the one or more axes, the testing probe module moves the probe head along a different axis (e.g., the Z axis) to move the probe head towards the printed circuit board for contact. The testing probe module also rotates the probe head to a target orientation relative to the printed circuit board. The borescope captures an image of the probe head relative to a region of a printed circuit board assembly being tested. The force sensor acquires force measurements that enable the system to control a contact impedance transition upon the probe head contacting a component on the printed circuit board assembly. Based on feedback provided by sensor data acquired by the borescope and the force sensor, the automated testing system can verify proper contact between the probe head and the printed circuit board assembly before conducting electrical tests.

Upon contacting the printed circuit board at one or more target locations, the automated testing system uses one or more testing probe modules to perform various electrical tests, including vector network analysis tests. The testing probe module measures full channel scattering parameters and/or single ended, differential mode, or common mode measurements. In some embodiments, the testing probe module acquires measurements in the frequency domain or the time domain. The acquired electrical measurements are used by a VNA module to characterize the electrical circuits on the printed circuit board assembly (e.g., calculating input impedance, frequency response, and isolation), as well as identify performance test failures (e.g., impedance mismatches, drilling issues, and bad back drills). The automated testing system provides the electrical measurements and any performance test failures for evaluation of the printed circuit board assembly.

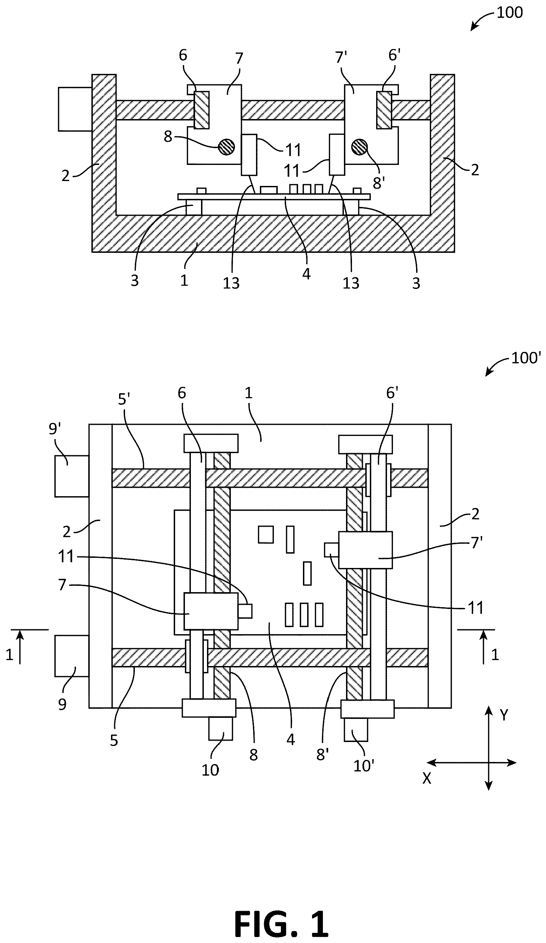

Figure 1 illustrates side and top views of a section of an example radio frequency (RF) test system 100, according to various embodiments. As shown, the RF test system 100 includes, without limitation, a frame comprising a baseplate 1 and a plurality of cheeks 2, a plurality of holders 3, a plurality of spindles 5 (e.g., 5, 5'), a plurality of transverse spindles 8 (e.g., 8, 8'), a plurality of cross members 6 (e.g., 6, 6') a plurality of drive motors 9 (e.g., 9, 9'), and a different plurality of drive motors 10 (e.g., 10, 10'), a plurality of shuttles 7 (e.g., 7, 7') , and a printed circuit board assembly (PCBA) 4. The shuttle 7 includes, without limitation, a radio frequency (RF) probe module 11. The RF probe module 11 includes, without limitation, a needle 13.

In various embodiments, the frame accommodates the baseplate 1, using the holders 3, the PCBA 4 for testing. The PCBA 4 is a device under test (DUT) and includes an array of integrated circuits (ICs) and/or other electronic components. The frame also holds two spindles 5, 5' that each extend between the respective cheeks 2 of the frame. The spindles 5, 5' extend in a traversing direction, hereinafter referred to as the X-direction. The cross-members 6, 6' run on said spindles 5, 5'; one being driven by the spindle 5 and the other by the spindle 5'. The shuttles 7, 7' run on the cross-members 6, 6' and are driven in the Y-direction by transverse spindles 8, 8' mounted on the cross-members 6, 6' parallel thereto. The plurality of drive motors 9, 9' are provided for the spindles 5, 5' and the plurality of drive motors 10, 10' for the transverse spindles 8, 8'. With the RF test system 100, the shuttles 7, 7' can be traversed over in the x-axis direction and/or the y-axis direction to any desired point of the circuit board assembly 4 by appropriate control of the motors 9, 9', 10, 10'.

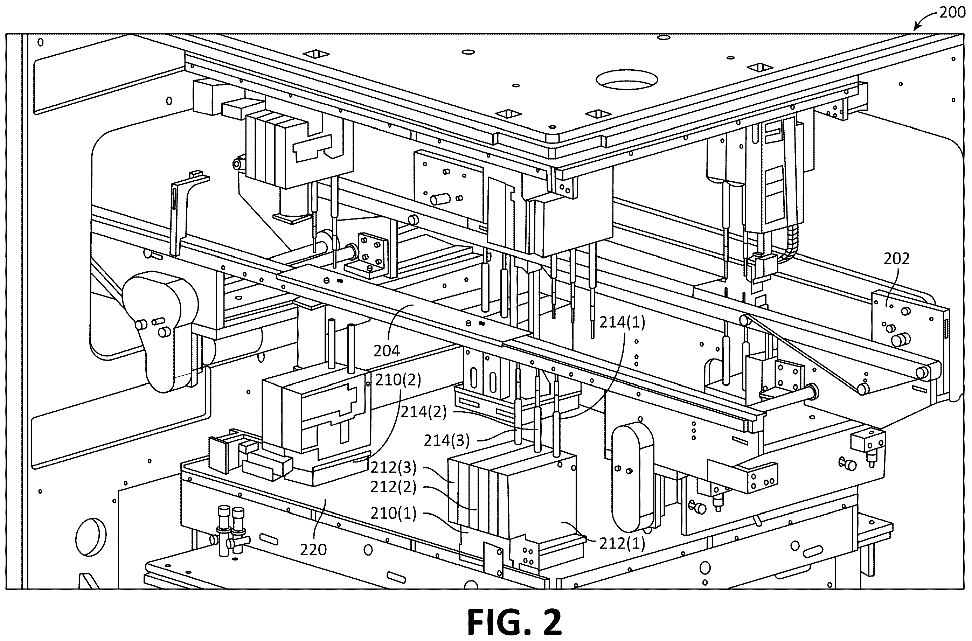

In some embodiments, the test system can include multiple shuttles 7 (e.g., two to twelve). As will be discussed in relation to Figure 2, in some embodiments, the shuttles 7 move using a different drive system (e.g., a state on which the shuttles 7 traverse). Each of the shuttles 7, 7' carries one or more RF probe modules 11 for a probe disposed at the end of a probe head (e.g., one or more needles 13). Additionally or alternatively, in some embodiments, the shuttles 7, 7' can ride on a bed of air in lieu of the cross-members 6, 6'.

In some embodiments, an RF probe module 11 or a similar module can hold a camera module (not shown). A drive system is provided in the RF probe modules 11 to enable the needles 13 to be raised and lowered (e.g., traverse in the Z-axis direction) and/or rotated (e.g., rotate from 0° to 270°). By raising needles 13 above various types of standard electronic components, there will be needle access to otherwise inaccessible target locations on PCB 4. The RF probe modules 11 provided in the X-direction and the Y-direction have to be moved for each change of location of one of the probe points. For example, the RF probe modules 11 can be moved 60 cm in the X-direction and 40 cm in the Y-direction, with the positioning accuracies of less than 1/10 mm. In order to simplify the drawing, leads that extend from the probes to an electronic test device (not shown) and the electronic test device itself are omitted from the drawing. In various embodiments, the RF test system 100 includes one or more cameras to determine the location of the head along the X-direction, Y-direction, and/or Z-direction. The RF test system 100 can receive feedback from a calibration module that controls the positioning of the needles 13 and controls the force at which the needle 13 contacts the circuit board 4.

By means of the RF test system 100, the circuit board 4 can be contacted, for example, at two electrical junctions at any time and, for example, the current-flow resistance can be determined. In some embodiments, the RF test system 100 illustrated is equipped with more probes. For example, there may be more than two cross-members 6, 6' provided, a plurality of shuttles 7, 7' on each of the cross-members 6, 6', and/or a plurality of RF probe modules 11 included in a given shuttle 7 so that a large number of probes can be used.

Figure 2 illustrates another example automated testing system 200, according to various embodiments. As shown, the automated test system 200 includes, without limitation, a conveyor system 202, an assembly holder 204, a plurality of shuttles 210 (e.g., 210(1), 210(2), etc.), and a stator 220. The shuttle 210 includes, without limitation, a plurality of probe modules 212 (e.g., 212(1), 212(2), etc.). One or more of the probe modules 212 include, without limitation, a probe head 214.

In operation, the automated testing system 200 acts as a flying probe tester, where the probes "fly" (e.g., move to different locations) to perform tests at different test points. The shuttles 210 respond to commands from a calibration module or a testing module (not shown) to move the plurality of probe modules 212 to target locations. One or more probe modules 212 control one or more probe heads 214 to contact the PCBA. Upon contacting the PCBA, the calibration module verifies that the one or more probe heads 214 are contacting the PCBA at the proper location and at the proper orientation, and with the proper force. The testing module then drives the one or more probe heads 214 to acquire electrical measurements and transmit the electrical measurements to the testing module for further computation.

As shown, the conveyor system 202 uses the assembly holders 204 to move a device-under-test (DUT), such as the PCBA 4. In various embodiments, the conveyor system 202 responds to one or more commands to move the assembly holders 204 along the conveyor tracks to a specific location. In such instances, the calibration module can identify target locations for the probe heads to contact based on the specific location where the PCBA 4 is located.

The plurality of shuttles 210 are located above and below the conveyor system 202. In such embodiments, the plurality of shuttles 210 enables the automated testing system 200 to test two-sided PCBAs, as probe heads 214 can reach contact points on the top and bottom sides of a given PCBA. The one or more shuttles 210 included a plurality of shuttles that respond to commands by the calibration module and/or the testing module. Upon receiving a command, a given shuttle 210 responds by moving on the bed of air along the stator 220 to a target location. Each shuttle 210 includes a plurality of probe modules 212. In such instances, the shuttle 210 can receive commands to move to a target location based on the types of probe modules 212 that are mounted to the shuttle 210.

In various embodiments, the probe modules 212 are one of a plurality of types of probes that are used during testing. In various embodiments, one or more of the probe modules 212 includes a probe head 214. In some embodiments, one or more probe modules 212 include other testing equipment (e.g., one or more LED analyzers, barcode readers, laser scanners, thermoscan cameras, etc.). For example, one of the probe modules 212 can be a camera module that acquires image data for a region of the PCBA 4. In such instances, the camera module is distinct from one or more borescopes that are disposed proximate to the one or more probe heads 214. When the respective shuttles 210 move to target locations, one or more probe modules 212 move the one or more probe heads 214 to target locations on the PCBA 4. In various embodiments, the probe module 212 controls the {*x*, *y*, z} coordinates of the probe head 214 relative to the PCBA 4 to provide six degree-of-freedom (6 DOF) of the probe head 214 within the automated testing system 200. Additionally, or alternatively, in various embodiments, the probe module 212 can include one or more head rotation modules that control the rotation of the probe head 214 relative to the x-axis, y-axis and z-axis. In such instances, the head rotation module controls rotation of the probe head up to 270° about a given plane.

In various embodiments, the one or more probe heads 214 contact the PCBA 4 at the target locations. Upon verification, the automated testing system 200 can perform one or more electrical tests and analysis. Such analysis includes eye diagram analysis, return loss analysis, and time domain reflectometry (TDR) that are used to verify the high-frequency performance of a PCBA 4. In some embodiments, the automated testing system 200 includes an electrical RF calibration module (not shown). In such instances, the electrical RF calibration module can use de-embedding techniques and a multi-step short-open-load-through (SOLT)-based calibration process for cables and fixtures. The probe de-embedding technique utilizes reference plane adjustments for precise calibration and scattering parameter ("S-parameter") measurements.

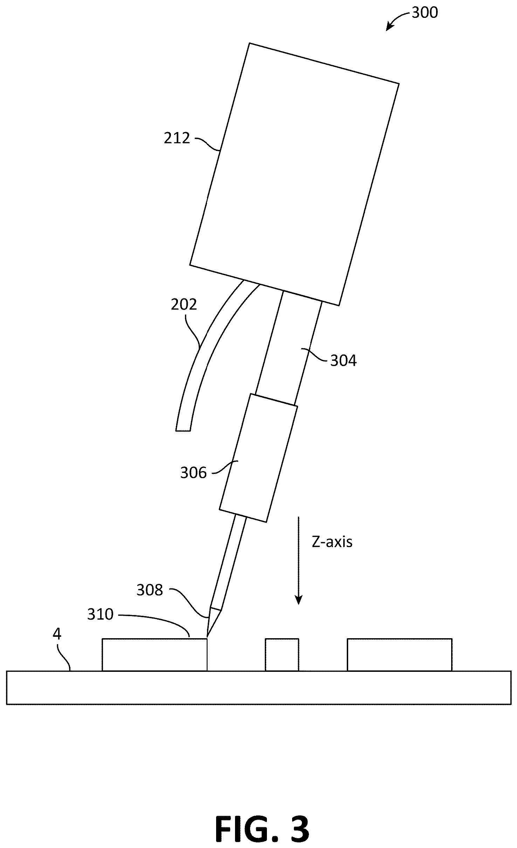

Figure 3 illustrates an example probe module 212 included in the example automated testing system 200 of Figure 2, according to various embodiments. As shown, the configuration 300 includes, without limitation, the probe module 212 and the circuit board 4. The probe module 212 includes, without limitation, a borescope 302, a force sensor 306, and a contact point 308. The circuit board 4 includes, without limitation, one or more electrical contacts 310.

The probe module 212 includes a probe head 304, which bears a contact point 308 as the probe at its distal end. In various embodiments, the probe head 304 and contact point 308 is pitched relative to a Z-direction, with different types of probe modules 212 having different contact points 308 and/or pitches. In various embodiments, the probe module 212 includes one or more drives for movement in the X-direction and the Y-direction (e.g., in the plane of the circuit board 4), and in the Z-direction normal to the plane of the circuit board 4. The probe head 304 can be brought into any desired pivoted position by movement by means of the drives in the X-direction, Y-direction, and/or the Z-direction. In some embodiments, the probe module 212 comprises a vertical drive which moves the probe head 304 vertically as a whole.

In various embodiments, the probe module 212 includes a set of cameras. The set of cameras can include the borescope 302, where the borescope 302 captures images of the contact point 308 in the Z-direction relative to the circuit board 4. In such instances, one or more additional cameras (not shown) can capture images of the contact point 308 along the X-direction and/or the Y-direction. In some embodiments, the probe module 212 includes an illumination device. For example, the borescope 302 can include a plurality of fiber-optic cables that provide a mechanism so that illumination from a light source (not shown) can be projected toward the contact point 308. Alternatively, in some embodiments, the illumination device is a separate component, such as a separate tube extending from the probe module 212.

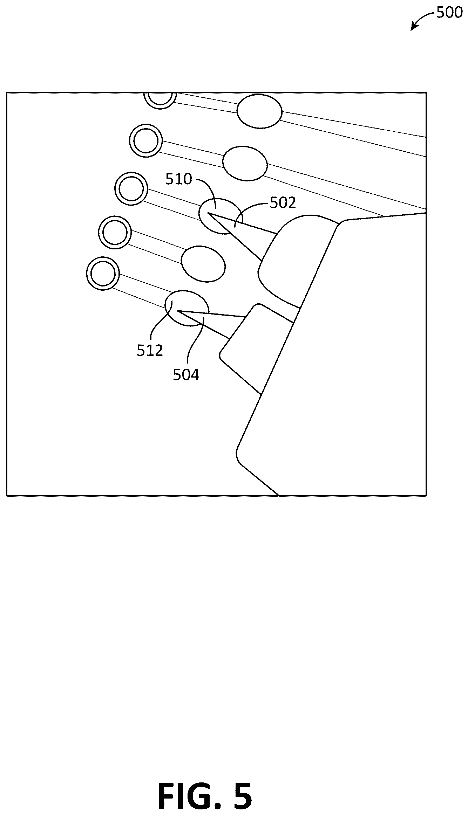

As will be discussed in further detail in relation to Figure 5, the borescope 302 acquires images of the illuminated region around the contact point 308. In various embodiments, the borescope 302 provides a 120° field of view of the contact point 308 and a region around the contact point 308. The borescope 302 can then transmit the images to an image processing system (not shown) and/or the calibration module to verify that the contact point 308 is contacting the electrical contact 310 at the proper location while using the proper orientation (e.g., pitch in the z-direction). In various embodiments, the calibration module provides feedback to the automated test system 200 to control the positioning of the contact point 308. For example, the calibration module can automatically generate commands for the probe module 212 to rotate the probe module 212 about the X-axis, Y-axis, and/or Z-axis upon determining that the contact point 308 is misaligned from a target location on the circuit board 4. Additionally, or alternatively, in various embodiments, the force sensor 306 measures the force exerted by the contact point 308 on the electrical contact 310. In such instances, the probe module 212 can transmit the force measurement to the calibration module. The calibration module can then control the probe module 212 such that the contact point 308 is contacting the electrical contact 310 using an optimal contact force.

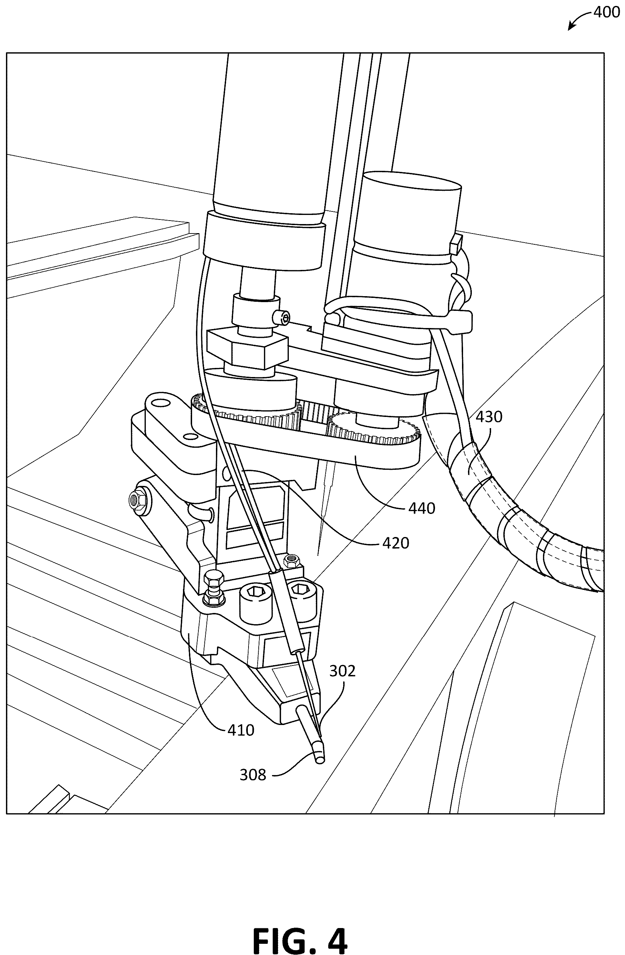

Figure 4 illustrates another view of the example RF probe module of Figure 3, according to various embodiments. As shown, the RF probe module 400 includes, without limitation, a probe head 410, the contact point 308, the borescope 302, an illumination device 420, matched cables 430, and one or more head rotation module 440.

In various embodiments, the RF probe module 400 can control one or more types of probe heads. For example, the probe head 410 can be an air coplanar probe (ACP). In some embodiments, the types of probe head 410 that the RF probe module 400 can control can include a fixed-pitch compliant (FPC) probe, a vector network analyzer (VNA) type probe, an active probe, or a differential probe. In various embodiments, the various types of probe heads 410 can include varying numbers of conductors based on the probe configuration. For example, a probe can include two or more contact points to enable a wider range of electrical tests. The RF probe module 400 is configured to accommodate a mixture of standard test probe modules to perform other test and measurement functions.

The borescope 302 focuses on the landing of the contact point 308. The borescope 302 is mounted on the RF probe module 400 in a manner that enables up to 260° of probe tip rotation via the head rotation module 440. In this manner, the borescope 302 enables a wider range of angular rotation and coverage. As shown, the borescope 302 includes a fiber-optic cable that is coupled to the illumination device 420. The illumination device 420 illuminates in the same direction as the borescope 302, projecting light toward the contact point 308.

In various embodiments, the matched cables 430 can include one or more matched cable sets that connect testing instruments (e.g., a VNA module, a calibration module, an electrical RF testing module, etc.) to the probe module 400. In some embodiments, the RF probe module 400 enables integration of various VNA Probe Types. The VNA probe types can be used in lieu of standard test (pogo-pin type) probe tips.

Figure 5 illustrates an image 500 captured by the borescope included in the example RF probe of Figure 3, according to various embodiments. As shown, the image 500 includes the contact points 502 and 504 that contact the electrical contacts 510 and 512 on the PBCA 4.

In operation, the borescope 302 acquires the image 500 in the Z-direction of the contact points 502, 504. In various embodiments, the RF probe can include multiple (e.g., three or more) contact points. When conducting an electronic test, the borescope captures the image 500 and transmits the image 500 to the image processing system and/or the calibration module. In such instances, the calibration module can acquire and process the image 500 to identify the location and orientation of the contact points 502, 504. Based on the determined position and orientation, the image processing system and/or the calibration system can verify that the probe head 410 is contacting the PCBA 4 at the target location. In some embodiments, the calibration module can also verify that the probe head 410 is contacting the PCBA 4 using the appropriate orientation.

Additionally, or alternatively, the calibration module can process one or more force measurements that the force sensor 306 acquired to verify whether the probe head 410 is contacting the PCBA 4 using the appropriate force. When the calibration module determines that the probe head 410 is not making the applicable contact or is not at the applicable position or orientation, the calibration module can send a command to the shuttle 210 and/or the RF probe module 400 to adjust the position of the contact points 502, 504. Upon contacting the electrical contacts 510, 512 at the correct position and using the correct force via the contact points 502, 504 the RF probe module 400 can conduct a contact impedance transition and acquire electrical measurements as part of a circuit analysis.

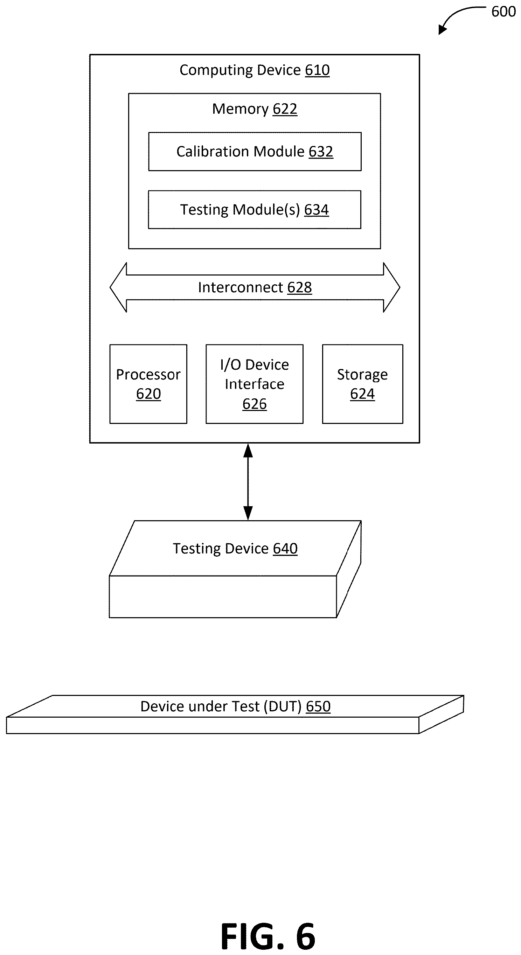

Figure 6 illustrates an example automated test system of Figure 2 performing a test of a device under test 650, according to various embodiments. As shown, the configuration 600 includes a computing device 610, a testing device 640, and a device under test (DUT) 650. The computing device 610 includes, without limitation, a processor 620, a memory 622, storage 624, an input/output (I/O) device interface 626, and an interconnect 628. The memory 622 includes, without limitation, a calibration module 632 and a one or more testing modules 634.

In operation, the processor 620 executes instructions from one or more modules 632, 634 stored in the memory 622 to control the testing device 640. In such instances, a given module 632, 634 can receive data from the testing device 640 and can transmit commands to the testing device 640 to control the operation of the testing device 640. Such operations include calibration of the testing device 640 (e.g., a shuttle 210, one or more probe device 212, one or more probe heads 214, etc.) and/or operation of one or more electrical tests on the DUT 650.

The computing device 610 is configured to implement one or more aspects of the various embodiments. In some examples, the computing device 610 individually controls one or more of the shuttles 210 and/or the probe modules 212. In various embodiments, the computing device 610, a controller device (not shown) that is included in the testing device 640, and/or other components (e.g., probes, cables, and connectors) of the device 640 can also work in concert to control the position and/or orientation of one or more probe heads 214 and control the flow of electricity during electrical tests to test one or more components of the DUT 650. The computing device 610 is also configured to receive one or more measurement signals from the testing device 640, compare the one or more measurement signals to one or more predetermined and/or configurable thresholds and record a quality control result (e.g., pass, fail and/or the like) based on the comparison.

In some embodiments, the computing device 610 includes a processor 620, a memory 622, a storage 624, an I/O device interface 626, and an interconnect 628. Computing device 610 includes a desktop computer, a laptop computer, a smart phone, a personal digital assistant (PDA), tablet computer, or any other type of computing device configured to receive input, process data, and optionally display images, and is suitable for practicing one or more embodiments. The computing device 610 described herein is illustrative and any other technically feasible configurations that fall within the scope of the present disclosure.

The processor(s) 620 includes any suitable processor implemented as a central processing unit (CPU), a graphics processing unit (GPU), an application-specific integrated circuit (ASIC), a field programmable gate array (FPGA), an artificial intelligence (AI) accelerator, any other type of processor, or a combination of different processors, such as a CPU configured to operate in conjunction with a GPU. In general, the processor(s) 620 may be any technically feasible hardware unit capable of processing data and/or executing software applications. Further, in the context of this disclosure, the computing elements shown in the computing device 610 may correspond to a physical computing system (e.g., a system in a data center) or may be a virtual computing instance executing within a computing cloud.

The I/O device interface 626 enables communication of I/O devices with the processor(s) 620. The I/O device interface 626 generally includes the requisite logic for interpreting addresses corresponding to I/O devices that are generated by the processor(s) 620. I/O device interface 626 may also be configured to implement handshaking between the processor(s) 620 and the I/O devices, and/or generate interrupts associated with I/O devices. I/O device interface 626 may be implemented as any technically feasible CPU, ASIC, FPGA, any other type of processing unit or device. I/O devices include devices capable of providing input, such as a keyboard, a mouse, a touch-sensitive screen, a microphone, a remote control, a camera, and so forth, as well as devices capable of providing output, such as a display device. Additionally, I/O devices may include devices capable of both receiving input and providing output, such as a touchscreen, a universal serial bus (USB) port, and so forth. I/O devices may be configured to receive various types of input from an end-user of the computing device 610, and to also provide various types of output to the end-user of the computing device 610, such as displayed digital images or digital videos or text. In some embodiments, one or more of I/O devices are configured to couple the computing device 610 to a network. A network includes any technically feasible type of communications network that allows data to be exchanged between the computing device 610 and external entities or devices, such as a web server or another networked computing device. For example, a network may include a wide area network (WAN), a local area network (LAN), a wireless (WiFi) network, and/or the Internet, among others.

The memory 622 includes a random access memory (RAM) module, a flash memory unit, or any other type of memory unit or combination thereof. The processor(s) 620, the I/O device interface 626, and the network interface are configured to read data from and write data to the memory 622. The memory 622 includes various software programs that can be executed by the processor(s) 620 and application data associated with said software programs, including the calibration module 632 and one or more testing modules 634 that perform individualized and/or group electrical tests on the DUT 650.

In various embodiments, the calibration module 632 included in the computing device 610 receives data from the testing device 640 and generates commands based on the data. In some embodiments, the calibration module 632 acquires image data, such as the images (e.g., the image 500) acquired from a borescope 302 included in the testing device 640. Additionally, or alternatively, in some embodiments, the calibration module 632 receives sensor data, such as force measurements that were acquired by the force sensor 306 included in the test device. In such instances, the calibration module 632 can process the data to calibrate the operation of the testing device 640.

For example, the calibration module 632 can process the image data acquired by the borescope 302 to determine the location and orientation of one or more contact points included in the test device (e.g., the contact points 502, 504). The location and orientation can then by used to verify whether the probe head 214 is contacting the DUT 650 at the one or more contact points. In some embodiments, the calibration module 632 can also process force measurements to verify whether the probe head 214 is contacting the DUT 650 using the appropriate force. When the calibration module 632 determines that the probe head 214 is not at the applicable position or orientation or the probe head 214 is not contacting the applicable force, the calibration module 632 can send one or more commands to the shuttle 210 and/or the RF probe module 212 to adjust the position of the contact points of the probe head 214. In such instances, the calibration module 632 can iteratively process data acquired by the testing device 640 and generate commands to adjust the testing device 640 before completing verification.

In various embodiments, the one or more testing modules 634 can include one or more types of testing modules that perform various types of tests on the DUT 650. For example, the one or more testing modules 634 can include a VNA module, an electrical RF testing module, a circuit analysis module, and so forth. In such instances, one of the testing modules 634 can select a particular test to run (e.g., an S-parameter test) and the computing device 610 generates one or more commands to move the testing device 640 to a target location for the contact points to contact target locations (e.g., the electrical contacts 510, 512) on the DUT 650 (e.g., an electronic printed board assembly that includes one or more electrical and/or electronic components).

For example, the probe module 212 can complete a loopback path to test the electrical properties of a given electronic circuit included in the DUT 650. Various capabilities of a given probe module 212 included in the testing device 640 (e.g., the RF probe module 400) include measuring full channel S-parameters. The S-parameters provide a framework for describing RF networks based on the ratio of incident and reflected microwaves. The S-parameters are thus useful for circuit design, as the S-parameters can be used to calculate properties, such as input impedance, frequency response, and isolation. The probe module 212 can also acquire, single ended, differential mode, mixed mode, or common mode measurements, S-parameters in frequency domain, and time-domain reflectometer (TDR) S-parameters in time domain.

In various embodiments, the probe module 212 records insertion loss and return loss. Additionally, or alternatively, the probe module 212 can acquire the electrical measurements to enable the one or more testing modules 634 (e.g., the VNA module and/or the electrical RF testing module) to identify performance test failures (e.g., impedance mismatches, drilling issues, and bad back drills). In such instances, the computing device 610 provides the electrical measurements and any performance test failures for evaluation of the DUT 650 via the I/O device interface 626.

Storage 624 includes non-volatile storage for applications and data, and may include fixed or removable disk drives, flash memory devices, and CD-ROM, DVD-ROM, Blu-Ray, HD-DVD, or other magnetic, optical, or solid state storage devices. The storage 624 may be a disk drive storage device. Although shown as a single unit, the storage 624 may be a combination of fixed and/or removable storage devices, such as fixed disc drives, floppy disc drives, tape drives, removable memory cards, or optical storage, network attached storage (NAS), or a storage area-network (SAN). Software programs, including one or more LED testing applications that perform individualized and/or group LED tests may be stored in storage 624 and loaded into memory 622 when executed.

The interconnect 628 is inclusive of any technically feasible internal and/or external data busses, memory busses, system busses, expansion busses and/or the like. The interconnect 628 includes a collection of electrical pathways that allows data, addresses, and control signals to be transferred between the various components of the computing device 610 and/or external devices and components. While discussed in the singular for clarity, the interconnect 628 is illustrative of one or more interconnects 628 that connect, for example, the processor 620 to the memory 622 and/or the storage 624, connects the computing device 610 to other devices including the testing device 640, I/O devices, peripheral devices, other computing devices, and/or the like. In some embodiments, the interconnect 628 incudes PCI Express (PCIe) connections for high-speed internal connections and Universal Serial Bus (USB) connections for connecting external devices.

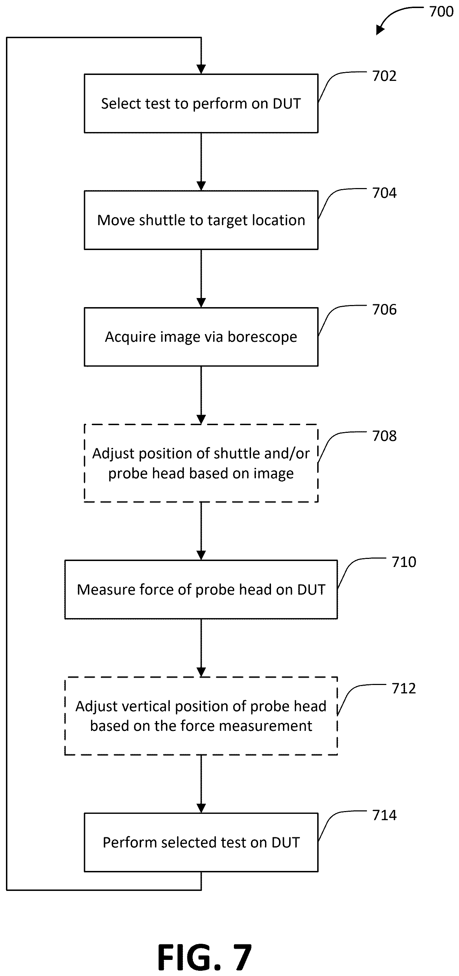

Figure 7 is a flow diagram of method steps for testing of a device under test, according to various embodiments. Although the method steps are described in conjunction with the systems and components of Figures 1-6, persons of ordinary skill in the art will understand that any system configured to perform the method steps, in any order, is within the scope of the invention.

As shown, a method 700 begins at step 702, where an automated testing system selects a test to perform on a device under test. In various embodiments, at least one testing module 634 selects a test to perform on the DUT 650. For example, the testing module 634 can comprise a RF testing module that selects an electrical test to perform when portion of the DUT 650 is operating at high frequencies (e.g., above 40 GHz). In such instances, the testing module 634 and/or the calibration module 632 responds to the selected test.

At step 704, the automated testing system moves a shuttle to a target location. In various embodiments, upon determining the selected test by identifying a target location that is based on the components that are to be tested on the DUT 650. For example, the testing module 634 can identify a target location that enables the probe head 214 of the testing device 640 to contact an electronic component on the DUT 650 with an applicable location and with an appropriate force. In such instances, the calibration module 632 and/or the testing module 634 can generate one or more commands that move a shuttle 210 included in the automated testing system 200 to a position that enables one or more probe heads 214 to reach the target location.

At step 706, the automated testing system acquires an image via a borescope. In various embodiments, the calibration module 632 receives an image that the borescope 302 included in the testing device 640 acquired. For example, upon the shuttle 210 moving to the target location, the probe module 214 can move the probe head proximate to the target location on the DUT 650. In such instances, the borescope can acquire one or more images of one or more contact points (e.g., the contact points 502, 504) a view of a portion of the DUT 650.

At step 708, the automated testing system optionally adjusts the position of the shuttle and/or the probe head based on the image. In various embodiments, the calibration module 632 determines that the one or more contact points of the probe head 214 are not at the applicable position or orientation. In such instances, the calibration module sends a command to the shuttle 210 and/or the RF probe module 214 to adjust the position of the contact points relative to the target location. In some embodiments, the calibration module 632 can iteratively perform steps 706 and 708 to perform multiple adjustments before verification that the contact points of the probe head 214 are at the target location.

At step 710, the automated testing system measures the force of the probe head 214 on the DUT 650. In various embodiments, the calibration module 632 receives force measurements transmitted by the force sensor 306 included in the testing device 640. The force sensor 306 acquires the force measurements upon the one or more contact points of the probe head 214 contacting the electrical contacts of the DUT 650. In such instances, the calibration module 632 processes the force measurements acquired by the force sensor 306 to verify that the probe head 410 is contacting the DUT 650 using the appropriate force.

At step 712, the automated testing system optionally adjusts the vertical position of the probe head 214 based on the force measurement. In various embodiments, the calibration module 632 attempts to verify whether the probe head 214 is contacting the DUT 650 with the appropriate force. When the calibration module 632 determines that the probe head 214 is not making the applicable contact, the calibration module 632 can send a command to the probe module 214 to adjust the vertical position of the probe head 214 to adjust the force the contact points are placing upon the DUT 650.

At step 714, the automated testing system performs the selected test on the DUT 650. In various embodiments, the calibration module 632 confirms that the electrical contacts of the probe head 214 are at the correct position and are using the correct force. In such instances, the testing module 634 performs the selected test on the DUT 650. In some embodiments, the probe module 214 can conduct a contact impedance transition and acquire electrical measurements as part of a circuit analysis. For example, the testing module 634 can measure full channel S-parameters, single ended, differential mode, mixed mode, or common mode measurements, S-parameters in frequency domain, and time-domain reflectometer (TDR) S-parameters in time domain. Additionally, or alternatively, in some embodiments, the testing module 634 causes the testing device 640 to record insertion loss and/pr return loss. In such instances, the testing module 634 can identify performance test failures (e.g., impedance mismatches, drilling issues, and bad back drills) based on the acquired measurements. The computing device 610 can then provide the electrical measurements and any performance test results associated with the evaluation of the DUT 650 via the I/O device interface 626.

In sum, the automated testing system and test probe module disclosed herein enable electrical measurements of printed circuit board assemblies to be measured when the printed circuit board is operating at high frequencies, including frequencies above 40 GHz. The automated testing system includes multiple shuttles that contain testing probe modules. Each of the testing probe modules includes a probe head that is movable and rotatable to contact the printed circuit board at a target location. In various embodiments, a calibration module included in the automated testing system performs optical calibration and electrical calibration to minimize inconsistencies associated with a loop formed by the testing probe module contacting a component on the printed circuit board. The shuttle includes a probe head, a borescope, and the testing probe module. The testing probe module further includes a force sensor. During testing, the shuttle and the testing probe module responds to commands by moving the probe head to a desired location and a desired position. The probe module and probe head flies over electronic components along one or more axes (e.g., X and Y axes). Once at the target position along the one or more axes, the testing probe module moves the probe head along a different axis (e.g., the Z axis) to move the probe head towards the printed circuit board for contact. The testing probe module can also rotate the probe head to a target orientation relative to the printed circuit board. The borescope captures an image of the probe head relative to a region of a printed circuit board assembly being tested. The force sensor provides feedback to control a contact impedance transition upon the probe head contacting a component on the printed circuit board assembly. Based on feedback provided by the borescope and the force sensor, the automated testing system can verify proper contact between the probe head and the printed circuit board assembly before conducting electrical tests.

Upon contacting the printed circuit board at one or more target locations, the automated testing system uses one or more testing probe modules to perform various electrical tests, including vector network analysis tests. The testing probe module measures full channel scattering parameters and/or single ended, differential mode, or common mode measurements. In some embodiments, the testing probe module acquires measurements in the frequency domain or the time domain. The acquired electrical measurements are used by a VNA module to characterize the electrical circuits on the printed circuit board assembly (e.g., calculating input impedance, frequency response, and isolation), as well as identify performance test failures (e.g., impedance mismatches, drilling issues, and bad back drills). The automated testing system provides the electrical measurements and any performance test failures for evaluation of the printed circuit board assembly.

At least one technical advantage of the disclosed techniques relative to the prior art is that, with the disclosed testing device, automated testing systems can acquire electrical measurements related to the operation of components of a printed circuit board assembly when operating at high frequencies. In particular, by using the disclosed techniques to validate the landing of a probe head on a location of the printed circuit board assembly, the probe testing module can automatically calibrate and confirm a proper connection between the probe testing module and components of the circuit board assembly before acquiring the electrical measurements. Consequently, automated testing systems can thus accurately test printed circuit board assemblies at high frequencies and minimize manual intervention. Further, the disclosed techniques can control the contact impedance transition between the probe head and the printed circuit board assembly to minimize signal degradation test signals at high frequencies, such as frequencies above 40 GHz. These technical advantages represent one or more technological improvements over prior art approaches.
1. In various embodiments, a method comprises positioning, by a testing probe module, a probe head relative to a location of a device under test, where the probe head and the testing probe module are included in a test device, acquiring, by a borescope included in the test device, an image of a probe head location relative to the location of the device under test, and contacting, by the probe head, the location on the device under test.
2. The method of clause 1, further comprising transmitting the image to a calibration module for optical calibration of the probe head.
3. The method of clause 1 or 2, further comprising performing, by the calibration module, short-open-load-through (SOLT)-based calibration for electrical radio frequency calibration of the testing probe module.
4. The method of any of clauses 1-3, where the testing probe module further includes a plurality of phase matched ultralow loss cables that connect the probe head to the calibration module.
5. The method of any of clauses 1-4, where the testing probe module further includes an illumination device coupled to the probe head and the borescope.
6. The method of any of clauses 1-5, where the borescope acquires the image in a Z-direction relative to the device under test and the probe head.
7. The method of any of clauses 1-6, further comprising acquiring, by a force sensor, a force measurement when the probe head contacts the location on the device under test, where the force sensor is included in the test device, and transmitting the force measurement to a calibration module, where the force measurement is usable by the calibration module to generate a command for the testing probe module to move the probe head.
8. The method of any of clauses 1-7, where the test device further includes a head rotation module that controls rotation of the probe head up to 270° about a plane perpendicular to a Z-direction relative to the probe head.
9. The method of any of clauses 1-8, further comprising acquiring, by the probe head, a plurality of scattering parameter measurements upon contacting the location on the device under test, and transmitting, by the test device, the plurality of scattering parameter measurements to a vector network analysis (VNA) instrument.
10. In various embodiments, a test device comprises a probe head for contacting a location on a device under test, a borescope for acquiring an image of a probe head location relative to the location on the device under test, and a testing probe module for positioning the probe head relative to the location of the device under test.
11. The test device of claim 10, where the borescope transmits the image to a calibration module for optical calibration of the probe head.
12. The test device of claim 10 or 11, where the calibration module further performs short-open-load-through (SOLT)-based calibration for electrical radio frequency calibration of the testing probe module.
13. The test device of any of claims 10-12, further comprising a plurality of phase matched ultralow loss cables that connect the probe head to the calibration module.
14. The test device of any of claims 10-13, further comprising an illumination device coupled to the probe head and the borescope.
15. The test device of any of claims 10-14, where the borescope acquires images in a Z-direction relative to the device under test and the probe head.
16. The test device of any of claims 10-15, further comprising a force sensor that acquires a force measurement when the probe head contacts the location on the device under test.
17. The test device of any of claims 10-16, where the probe head comprises a fixed-pitch compliant (FPC) probe, a vector network analyzer (VNA) type probe, or an air coplanar probe (ACP).
18. The test device of any of claims 10-17, further comprising a head rotation module to control rotation of the probe head up to 270° about a plane perpendicular to a Z-direction relative to the probe head.
19. The test device of any of claims 10-18, where the probe head acquires a plurality of scattering parameter measurements upon contacting the location on the device under test, and transmits the plurality of scattering parameter measurements to a vector network analysis (VNA) instrument.
20. In various embodiments, one or more non-transitory computer-readable media store program instructions that, when executed by one or more processors, cause the one or more processors to perform a method comprising positioning, by a testing probe module, a probe head relative to a location of a device under test, where the probe head and the testing probe module are included in a test device, acquiring, by a borescope included in the test device, an image of a probe head location relative to the location on the device under test, and contacting, by the probe head, the location on the device under test.

Any and all combinations of any of the claim elements recited in any of the claims and/or any elements described in this application, in any fashion, fall within the contemplated scope of the present invention and protection.

The descriptions of the various embodiments have been presented for purposes of illustration, but are not intended to be exhaustive or limited to the embodiments disclosed. Many modifications and variations will be apparent to those of ordinary skill in the art without departing from the scope and spirit of the described embodiments.

Aspects of the present embodiments may be embodied as a system, method, or computer program product. Accordingly, aspects of the present disclosure may take the form of an entirely hardware embodiment, an entirely software embodiment (including firmware, resident software, micro-code, etc.) or an embodiment combining software and hardware aspects that may all generally be referred to herein as a "module," a "system," or a "computer." In addition, any hardware and/or software technique, process, function, component, engine, module, or system described in the present disclosure may be implemented as a circuit or set of circuits. Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

Aspects of the present disclosure are described above with reference to flowchart illustrations and/or block diagrams of methods, apparatus (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine. The instructions, when executed via the processor of the computer or other programmable data processing apparatus, enable the implementation of the functions/acts specified in the flowchart and/or block diagram block or blocks. Such processors may be, without limitation, general purpose processors, special-purpose processors, application-specific processors, or field-programmable gate arrays.

The flowchart and block diagrams in the figures illustrate the architecture, functionality, and operation of possible implementations of systems, methods, and computer program products according to various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

While the preceding is directed to embodiments of the present disclosure, other and further embodiments of the disclosure may be devised without departing from the basic scope thereof, and the scope thereof is determined by the claims that follow.

## Claims

1. A method comprising:
positioning, by a testing probe module, a probe head relative to a location of a device under test, wherein the probe head and the testing probe module are included in a test device;
acquiring, by a borescope included in the test device, an image of a probe head location relative to the location of the device under test; and
contacting, by the probe head, the location on the device under test.

2. The method of claim 1, further comprising:
transmitting the image to a calibration module for optical calibration of the probe head.

3. The method of claim 2, further comprising:
performing, by the calibration module, short-open-load-through (SOLT)-based calibration for electrical radio frequency calibration of the testing probe module.

4. The method of either claim 2 or claim 3, wherein the testing probe module further includes a plurality of phase matched ultralow loss cables that connect the probe head to the calibration module.

5. The method of any one of the previous claims, wherein the testing probe module further includes an illumination device coupled to the probe head and the borescope.

6. The method of any one of the previous claims, wherein the borescope acquires the image in a Z-direction relative to the device under test and the probe head.

7. The method of any one of the previous claims, further comprising:
acquiring, by a force sensor, a force measurement when the probe head contacts the location on the device under test, wherein the force sensor is included in the test device; and
transmitting the force measurement to a calibration module, wherein the force measurement is usable by the calibration module to generate a command for the testing probe module to move the probe head.

8. The method of any one of the previous claims, wherein the test device further includes a head rotation module that controls rotation of the probe head up to 270° about a plane perpendicular to a Z-direction relative to the probe head.

9. The method of any one of the previous claims, further comprising:
acquiring, by the probe head, a plurality of scattering parameter measurements upon contacting the location on the device under test; and
transmitting, by the test device, the plurality of scattering parameter measurements to a vector network analysis (VNA) instrument.

10. A test device comprising:
a probe head for contacting a location on a device under test;
a borescope for acquiring an image of a probe head location relative to the location on the device under test; and
a testing probe module for positioning the probe head relative to the location of the device under test.

11. The test device of claim 10, wherein the borescope is configured to transmit the image to a calibration module for optical calibration of the probe head, wherein preferably the calibration module is configured to further perform short-open-load-through (SOLT)-based calibration for electrical radio frequency calibration of the testing probe module.

12. The test device of claim 11, further comprising:
a plurality of phase matched ultralow loss cables that connect the probe head to the calibration module.

13. The test device of any one of claims 10 to 12, wherein the borescope is configured to acquire images in a Z-direction relative to the device under test and the probe head.

14. The test device of any one of claims 10 to 13, further comprising:
a force sensor that is configured to acquire a force measurement when the probe head contacts the location on the device under test, and/or wherein the probe head comprises a fixed-pitch compliant, FPC, probe, a vector network analyzer, VNA, type probe, or an air coplanar probe, ACP.

15. One or more non-transitory computer-readable media storing program instructions that, when executed by one or more processors, cause the one or more processors to perform a method comprising:
positioning, by a testing probe module, a probe head relative to a location of a device under test, wherein the probe head and the testing probe module are included in a test device;
acquiring, by a borescope included in the test device, an image of a probe head location relative to the location on the device under test; and
contacting, by the probe head, the location on the device under test.
